# EUROPEAN PATENT APPLICATION

(11) **EP 4 560 331 A1**
(43) Date of publication of application: **28.05.2025**
(21) Application number: 24188622.5
(22) Date of filing: 15.07.2024
(51) Int. Cl.: G01R 31/367, G01R 31/385, G01R 31/392

(54) **BATTERY TEST APPARATUS AND METHOD**

(30) Priority: 27.11.2023 KR 20230166732
(71) Applicant: SAMSUNG SDI CO., LTD., Giheung-gu Yongin-si, Gyeonggi-do 17084 (KR)
(72) Inventor: Kim, Sungsoo, 17084 Yongin-si, Gyeonggi-do (KR); Lee, Jaehyoun, 17084 Yongin-si, Gyeonggi-do (KR); Lim, Byeonghui, 17084 Yongin-si, Gyeonggi-do (KR); Kim, Bora, 17084 Yongin-si, Gyeonggi-do (KR); Han, Jee Hoon, 17084 Yongin-si, Gyeonggi-do (KR); Kim, Jongman, 17084 Yongin-si, Gyeonggi-do (KR); Kim, Giheon, 17084 Yongin-si, Gyeonggi-do (KR)
(74) Representative: Gulde & Partner

(57) **Abstract**

A battery test apparatus and method may be provided. The battery test method for testing a battery (10) in a battery test apparatus (100, 1000) may include: generating a test pattern (300) in which a cycle (310) including at least one operation step for a test list and a loop (320) including the number of repetitions of the cycle (310) are set, based on user input; setting a tag (330, 332, 334) indicating a test type in the at least one operation step according to the test type within the cycle (310) for the test list; testing the battery (10) by charging and discharging the battery (10) according to the test pattern (300); and storing voltage data and current data in memory (1020) as test results for the test pattern (300).

## Description

### BACKGROUND

### (a) Field

This disclosure relates to battery test apparatus and method.

### (b) Description of the Related Art

A battery test apparatus may evaluate the electrical characteristics of battery cells by repeatedly charging and discharging of battery cells.

Among the data collected during charging and discharging of battery cells, only some are the meaningful data that are actually used for evaluation, and classification of meaningful data in the data collected may be done manually, which may consume a lot of time and money.

### SUMMARY

At least one of the embodiments may provide a battery test apparatus and a method that can quickly (or suitably) extract data to be extracted from battery test data.

In addition, at least one of the embodiments may provide a battery test apparatus and a method that can quickly (or suitably) extract meaningful data related to battery life from battery test data and perform battery life prediction using the extracted meaningful data.

According to one or more embodiments of an aspect of the present disclosure, a battery test method for testing a battery in a battery test apparatus may be provided. The battery testing method includes, generating a test pattern in which a cycle including at least one operation step for each test list and a loop including (e.g., indicating) the number of repetitions of the cycle are set, based on user input; setting a tag indicating a test type in at least one operation step according to the test type within the cycle for each test list; testing the battery by charging and discharging the battery according to the test pattern; and storing voltage data and current data in memory as test results for the test pattern.

The storing voltage data and current data may include tagging the information of the tag in a test result corresponding to an operation step in which the tag is set.

The test type may include at least one of an internal resistance of the battery, a capacity of the battery, a temperature of the battery, a life of the battery, a charge and discharge rate of the battery, and a formation of the battery.

The battery test method may include, receiving a life test command of the battery; extracting current data and voltage data for each cycle tagged with information of a tag indicating a life from the memory; and predicting the life of the battery using the current data and voltage data for each cycle.

The predicting the life of the battery may include at least one of, calculating capacity data for each cycle using the current data for each cycle; calculating capacity-to-voltage differential characteristic data for each cycle using the capacity data for each cycle and the voltage data for each cycle; and predicting the life of the battery from the capacity-to-voltage differential characteristic data for each cycle using a life prediction model.

Each of the at least one operation step may include at least one or any one of a charge step, a rest step, and a discharge step, and the each of the at least one operation step may further include an operation condition and an end condition.

According to one or more embodiments of another aspect of the present disclosure, a battery test apparatus for testing a battery may be provided. The battery test apparatus may include, a storage device; a charge-and-discharge device electrically connected to the battery and charging and discharging the battery according to a test pattern including at least one test list; and a controller that generates the battery pattern based on user input, provides the battery pattern to the charge-and-discharge device, controls testing of the battery, and stores test result data in the storage device in response to the battery pattern, wherein each of the at least one test list may include a cycle including at least one operation step and a loop including (e.g., indicating) the number of repetitions of the cycle, and the controller may set a tag indicating a test type in at least one operation step according to the test type.

The controller may tag test result data corresponding to the operation step in which the tag is set with the information of the tag, and may store the test result data tagged with the information of the tag.

The test type may include at least one of an internal resistance of the battery, a capacity of the battery, a temperature of the battery, a life of the battery, a charge and discharge rate of the battery, and a formation of the battery.

The controller may extract test result data tagged with information on a tag corresponding to a test type input from the user from the storage device, and may evaluate the test type using the extracted test result data.

The controller may extract test result data tagged with information on a tag indicating a life from the storage device based on a battery life test command, and may evaluate the life using the extracted test result data.

The controller may evaluate the life from the test result data extracted using a learned life prediction model.

Each of the at least one operation step may include at least one or any one of a charge step, a rest step, and a discharge step, and the each of the at least one operation step may further include an operation condition and an end condition.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

FIG. 1 is a diagram showing a battery test apparatus according to an embodiment.
FIG. 2 is a diagram showing an example of a battery according to an embodiment.
FIG. 3 is a diagram showing an example of a test pattern according to an embodiment.
FIG. 4 is a diagram showing a method of generating a test pattern in the controller shown in FIG. 1.
FIG. 5 is a flowchart showing a method for predicting the life of a battery in a battery test apparatus according to an embodiment.
FIG. 6 is a diagram showing a method of learning a life prediction model according to an embodiment.
FIG. 7 is a diagram showing an example of capacity-to-voltage differential characteristic data for each cycle in a learning sample.
FIG. 8 is a diagram showing an example of life data for each cycle in a learning sample.
FIG. 9 is a diagram showing a life prediction apparatus according to an embodiment.
FIG. 10 is a diagram showing a battery test apparatus according to another embodiment.

### DETAILED DESCRIPTION OF THE EMBODIMENTS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. The above terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

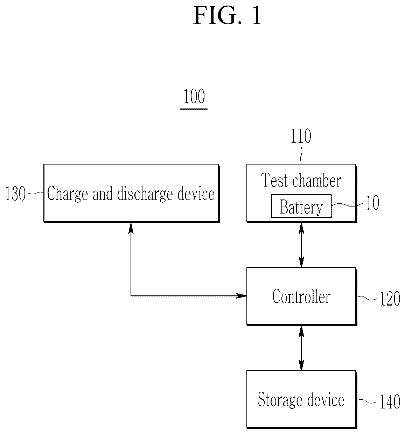

FIG. 1 is a diagram showing a battery test apparatus according to an embodiment.

Referring to FIG. 1, the battery test apparatus 100 may include a test chamber 110, a controller 120, a charge-and-discharge device 130, and a storage device 140.

The test chamber 110 may be configured to accommodate the battery 10 to be tested. Here, the battery 10 may be a battery module including a plurality of battery cells or may be a battery pack including at least one battery module.

The battery test apparatus 100 may perform a test on the battery 10 while the battery 10 may be mounted in the test chamber 110 and may be connected to the charge-and-discharge device 130 through a communication interface.

The charge-and-discharge device 130 may charge the battery 10 or may discharge the battery 10. The charge-and-discharge device 130 may charge or discharge the battery 10 based on a control signal from the controller 120. At this time, the control signal may include current value, charging rate, and/or discharging rate.

The controller 120 may perform a test on the battery 10 according to a test pattern. The controller 120 may generate the test pattern based on user input.

The test pattern may be commands that arrange the order, operations, and conditions for battery charging and discharging testing. The conditions may include test environment information, such as charge rate, discharge rate, charge end condition, discharge end condition, charge mode, discharge mode, and temperature. The operations may include a charging operation, a discharging operation, and a rest operation. As an example, a battery test pattern may be commands in which operations and conditions are sequentially listed, such as charging for 1 hour with a current of 1A, discharging for 10 seconds with a current of 10A, resting for 30 minutes, and charging for 1 hour with a current of 2A.

The controller 120 may generate control signals to control the charge-and-discharge device 130 according to the test pattern and transmit the control signals to the charge-and-discharge device 130.

The controller 120 may test the battery 10 in response to the test pattern and measure or collect data corresponding to the test result. The controller 120 may store data corresponding to test results in the storage device 140.

The controller 120 may display result data corresponding to a test pattern or result data corresponding to a specific operation step selected by the user. The controller 120 may display the result data in a graph according to the settings input by the user. The controller 120 may calculate other data using the result data corresponding to the test pattern, and may store and manage calculated other data. For example, the controller 120 may calculate capacity data by integrating current data.

The controller 120 may evaluate the performance of the battery 10 using data stored in the storage device 140. The controller 120 may extract meaningful data depending on the type of test (e.g., performance evaluation), from the data stored in the storage device 140, and may evaluate performance using the extracted data.

In an embodiment, the controller 120 may generate the test pattern using tags to quickly (or suitably) extract meaningful data depending on the type of performance evaluation. For example, the controller 120 may use tags to indicate which operation steps (or operations) in the test pattern are used for which performance evaluation. If a tag is set in a certain operation step, the test result data corresponding to the operation step may be tagged and stored with the corresponding tag information. In this way, the controller 120 may quickly (or suitably) extract meaningful data for the performance evaluation using the tag information.

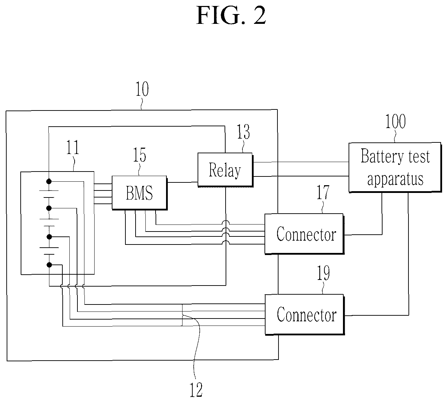

FIG. 2 is a diagram showing an example of a battery according to an embodiment.

Referring to FIG. 2, the battery 10 may include at least one battery module 11, a relay 13, and a battery management system (BMS) 15.

The battery 10 may be connected to the charge-and-discharge device (130 in FIG. 1) through the relay 13, and may be charged or discharged by the charge-and-discharge device (130 in FIG. 1).

The battery module 11 may include a plurality of cells electrically connected to each other in series and/or parallel.

The relay 13 may control the electrical connection between the battery module 11 and an external device. According to an embodiment, the external device may be a charger/discharger (e.g., charge-and-discharge device 130 in FIG. 1). If the relay 13 is turned on, the battery module 11 and the charge-and-discharge device (130 in FIG. 1) may be electrically connected so that charging or discharging may be performed, and if the relay 13 is turned off, the battery module 11 and charge-and-discharge device (130 in FIG. 1) may be electrically separated.

The BMS 15 may control and manage the overall operation of the battery 10. The BMS 15 may monitor the overall status of the battery module 11 and the cells included in the battery module 11. The BMS 15 may perform various control functions to adjust the state of the battery module 11 and the cells included in the battery module 11. For example, the BMS 15 may be electrically connected to a positive electrode and a negative electrode of each of a plurality of cells to measure or collect cell voltage. As another example, BMS 15 may measure or collect battery current and temperature. The BMS 15 may control the charge current and/or discharge current of the battery module 11 based on information such as cell voltage of the plurality of cells, battery current, and battery temperature, and may perform a cell-balancing operation for the plurality of cells. The BMS 15 may control the switching of the relay 13 to charge or discharge the battery module 11.

A connector 17 may be a connection device for connecting the BMS 15 and the battery test apparatus 100. The BMS 15 may provide measured data to the battery test apparatus 100 through the connector 17.

Another connector 19 may be a connection device for connecting the battery module 11 and the battery test apparatus 100. For example, the connector 17 may connect the battery test apparatus 100 with a plurality of lines 12 electrically connected to the positive electrode and to the negative electrode of each of the plurality of cells. Accordingly, the battery test apparatus 100 may measure the voltage of each cell or collect the voltage of each cell.

According to an embodiment, the battery test apparatus 100 may test the battery 10 by controlling the BMS 15 according to the test pattern, and the BMS 15 may measure cell voltage, battery current, and temperature, etc., and may provide the measured data to the battery test apparatus 100. The test pattern may be a kind of test scenario for testing.

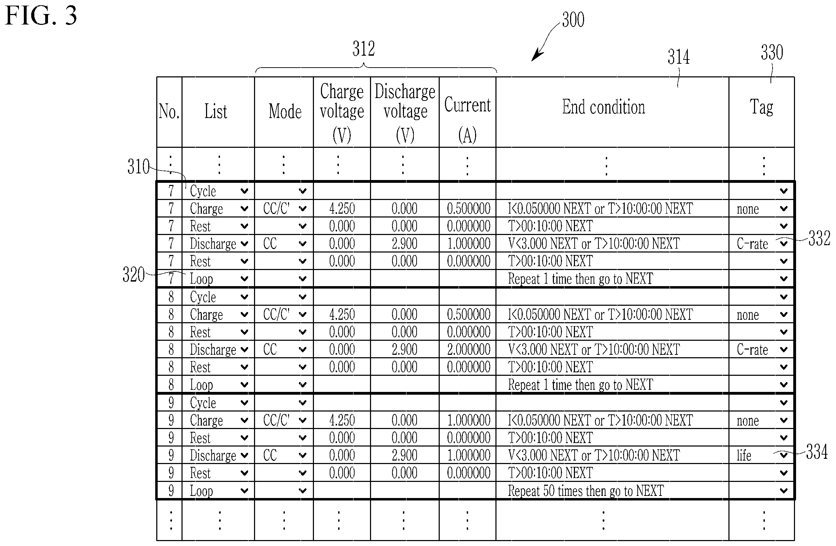

FIG. 3 is a diagram showing an example of a test pattern according to an embodiment.

Referring to FIG. 3, the battery test apparatus 100 may generate a test pattern 300 according to the test object and the type of test, or test type, to be tested for the test object.

In an embodiment, the test object may be battery 10. The type of test may be a characteristic item of the battery 10 to be tested, for example, it may include internal resistance of the battery 10, capacity of the battery 10, temperature of the battery 10, life of the battery 10, charge rate of the battery 10, discharge rate of the battery 10, the formation of the battery 10, etc.

The test pattern 300 may include a plurality of test lists. In FIG. 3, for convenience of explanation, only a 7-th test list, a 8-th test list, and a 9-th test list for one test object are shown.

Each test list may include cycles 310 and loops 320 representing test items. Each test list may further include a tag 330.

Each cycle may include a series of operation steps (or operations) performed in the corresponding test list, and each operation step may include an operation condition 312, and an end condition 314. The operation condition 312 may represent test conditions for the corresponding operation step and may include mode information, charge voltage, discharge voltage, and current.

As an example, the cycle in the 7-th test list may include the operation steps of a charge step, a rest step, a discharge step, and a rest step. Additionally, the operating condition of the charge step may include at least one of mode information, charge voltage, discharge voltage, and current. The mode information may indicate the type of charging or discharging. For example, the mode information may include at least one of constant current (CC) charge/discharge method, constant voltage (CV) charge/discharge method, CC and CV combination charge method, constant power (CP) charge/discharge method, and constant resistance (CR) discharge method. The unit of charge voltage and discharge voltage may be volt (V), and the unit of current may be ampere (A).

In FIG. 3, for convenience, the cycles of the 7-th test list, the 8-th test list, and the 9-th test list are all shown as operation steps of a charge step, a rest step, a discharge step, and a rest step, but the cycles in each test list may be set differently. For example, a cycle of any one test list may include only the operation steps of charge step and rest step. This may be determined based on user input.

The loop 320 may represent the number of repetitions of the cycle. The loop 320 may include a loop end condition. If "repeat 1 time" is set as the loop end condition, the loop may be set to 1, and after performing one cycle, the test operations in the next test list may be performed.

As an example, the cycle 310 of the 7-th test list may include operation steps of a charge step, a rest step, a discharge step, and a rest step, the charge step may include operation conditions of "a charge voltage of 4.25V, a current of 0.5A, and CC/CV mode," and the discharge step may include operation conditions of "a discharge voltage of 2.9V, a current of 1A, and CC mode." Each operation step may further include an end condition. The end condition of the charge step may include "I<0.050000 NEXT" or "T>10:00:00 NEXT", the end condition of the rest step may include "T>00:10:00 NEXT", and the end condition of the discharge step may include "V<3.000 NEXT" or "T>10:00:00 NEXT". In 7-th the test list, the loop end condition of the loop may include "repeat 1 time then go to NEXT." In the charge step, the operation condition of "charge voltage of 4.25V, current of 0.5A, and CC/CV mode" may indicate charging of the battery in "charge voltage of 4.25V, current of 0.5A, and CC/CV mode." In the discharge step, the operation condition of "a discharge voltage of 2.9V, a current of 1A, and CC mode" may indicate discharging of the battery 10 in "a discharge voltage of 2.9V, a current of 1A, and CC mode." The end condition "T>10:00:00 NEXT" in the charge step may indicate that if 10 hours have passed after the start of charging, ending the charge step and going to the rest step, which is the next operation step. In addition, "I<0.050000 NEXT" may indicate that if the current I of the battery 10 is less than 0.05A, ending the charge step and going to the rest step, which is the next operation step. The end condition in the discharge step, "V<3.000 NEXT" may indicate that if the battery voltage V is less than 3V in the discharge step, ending the discharge step and going to the rest step, which is the next operation step.

According to an embodiment, the controller 120 of the battery test apparatus 100 may set the tag 330 to an operation step (e.g. a predetermined operation step) in the test list according to the characteristic item of the battery 10 to be tested based on user input.

The controller 120 may test the battery 10 corresponding to the operation steps of each cycle in each test list, and may store the data measured in each operation step in response to each operation step. At this time, if the tag 330 is set in one operation step, in the controller 120, the data measured in the corresponding operation step may be tagged and stored with the corresponding tag information.

As an example, in cycle 310 of the 7-th test list, if the tag 332 of "C-rate" is set in the discharge step, the controller 120 may discharge the battery 10 according to the discharge step of the cycle 310 of the 7-th test list, may tag the measured current and voltage data with tag information of "C-rate" and may store current and voltage data tagged with tag information. The tag "C-rate" may indicate the characteristic item of charge and discharge rate.

As another example, the cycle of the 9-th test list may include operation steps of a charge step, a rest step, a discharge step, and a rest step, and the charge step may include the operation conditions of "a charge voltage of 4.25V, a current of 1A, and CC/CV mode," and the discharge step may include the operation conditions of "a discharge voltage of 2.9V, a current of 1A, and CC mode." Each operation step may further include an end condition. The end condition of the charge step may include "I<0.050000 NEXT" or "T>10:00:00 NEXT", and the end condition of the rest step may include "T>00:10:00 NEXT", and the end condition of the discharge step may include "V>3.000 NEXT" or "T>10:00:00 NEXT". In the 9-th test list, the loop end condition of the loop may include "repeat 50 times then go to NEXT." That is, after repeating the operation of the cycle 50 times, the next operation in the test list may be performed. At this time, the controller 120 may set a tag 334 called "life" in the discharge step of the cycle. Here, the tag "life" may represent a characteristic item of life of the battery (e.g., a lifespan of the battery).

The controller 120 may test the battery 10 according to 50 cycles, in the 9-th test list, and may store data measured in each operation step of each cycle in response to each operation step of each cycle. At this time, the data measured in each discharge step of each cycle may be tagged and stored with the tag information "life."

In this way, after the test of the battery 10 according to the test pattern is completed, the controller 120 may extract only data measured in 50 discharge steps of the 9-th test list using the tag information "life" among the data stored in the storage device 140.

In this way, the tag according to the embodiment may be used to quickly (or suitably) extract result data corresponding to a certain test command after test commands are executed.

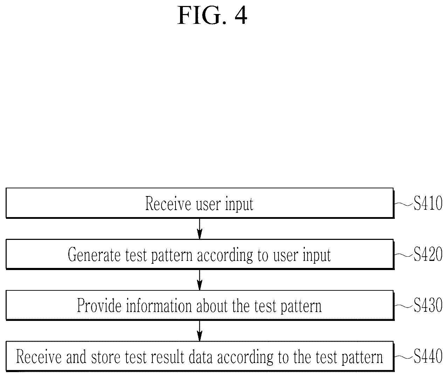

FIG. 4 is a diagram showing a method of generating a test pattern in the controller shown in FIG. 1.

Referring to FIG. 4, the controller 120 may receive user input for testing (S410).

The controller 120 may generate a test pattern according to user input (S420). The controller 120 may generate a test pattern as shown in FIG. 3 based on user input. The user input may include information about the cycle of each test list, information about the presence of a tag, tag type information, end condition information of the test list, operation conditions and end conditions of each operation step of the cycle, etc.

The controller 120 may provide information about the test pattern to the charge-and-discharge device 130 (S430), and may control the battery 10 according to the test pattern.

The charge-and-discharge device 130 may charge or discharge the battery 10 based on the test pattern.

The controller 120 may receive test result data according to charging and discharging of the battery 10 based on the test pattern, and may store the test result data according to the test pattern in the storage device 140 (S440). The test result data may include, for example, current data of the battery, voltage data of the battery, and temperature data.

The controller 120 may check whether each operation step has a tag, and if there is an action step in which the tag is set, the controller 120 may tag and store the corresponding tag information to the test result data according to the operation step in which the tag is set.

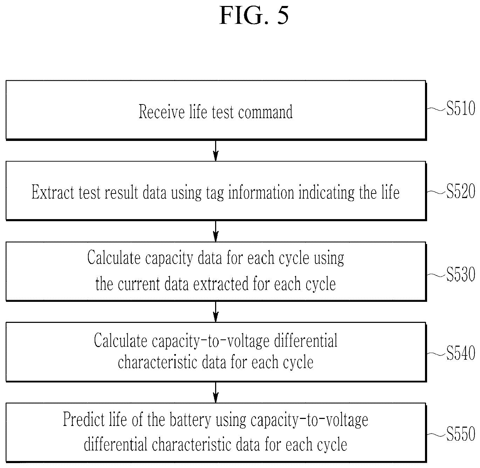

Below, an embodiment of predicting the life of a battery using data extracted from a battery test apparatus will be described with reference to FIGS. 5 to 9.

FIG. 5 is a flowchart showing a method for predicting the life of a battery in a battery test apparatus according to an embodiment.

Referring to FIG. 5, the controller 120 of the battery test apparatus 100 may receive a life test command (e.g., lifespan test command) from the user (S510).

First, it is assumed that a test operation of the battery 10 was performed according to the battery test method shown in FIG. 4, and test result data according to the test pattern was stored in the storage device 140.

The controller 120 may extract test result data using tag information of "life" indicating the life of the battery from the storage device 140 based on the life test command (S520). The controller 120 may extract test result data tagged with tag information of "life" indicating life from the storage device 140. As an example, if the battery 10 is tested according to the test pattern 300 shown in FIG. 3, the result data tested according to the 50 discharge steps among operation steps of the 9-th test list may be tagged with tag information of "life", and may be stored the tagged with the tag information of "life," and the result data tested according to the 50 discharge steps may be extracted using the tag information of "life."

The controller 120 may calculate capacity data for each cycle using the current data extracted for each cycle (S530), and may calculate capacity-to-voltage differential characteristic data for each cycle by differentiating the capacity data for each cycle into voltage data (S540).

The controller 120 may predict the life of the battery 10 using capacity-to-voltage differential characteristic data for each cycle (S550).

According to an embodiment, the battery test apparatus 100 may predict the life of the battery 10 using a life prediction model. The life prediction model may be a learned model. The battery test apparatus 100 may input capacity-to-voltage differential characteristic data for each cycle into the life prediction model. The lifespan prediction model may output a life prediction result of the battery 10 predicted from capacity-to-voltage differential characteristic data for each cycle. As one example, the life prediction model may predict that the remaining life of the battery 10 is "long" or "short." As another example, the life prediction model may predict the remaining life of the battery 10 as an approximate number of months.

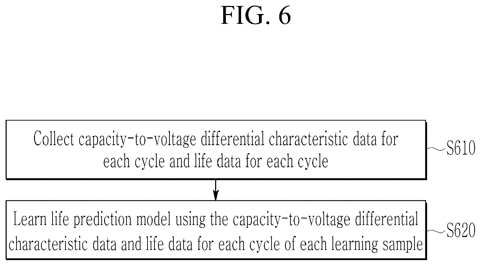

FIG. 6 is a diagram showing a method of learning a life prediction model according to an embodiment.

Referring to FIG. 6, the learning device may collect learning data (S610). The learning data may include capacity-to-voltage differential characteristic data and life data for each cycle of each learning sample. Here, the learning sample may be a battery. The learning device may be a separate device, and the function of the learning device may be implemented in the controller 120.

A test of the battery may be performed on the learning samples according to the test pattern shown in FIG. 3, and current and voltage data may be extracted among the test result data using tag information of "life" indicating life evaluation.

The capacity-to-voltage differential characteristic data for each cycle of the learning samples may be calculated using current and voltage data extracted using the tag information of "life" for the learning samples, and capacity data for each cycle may be calculated as life data for each cycle of the learning samples.

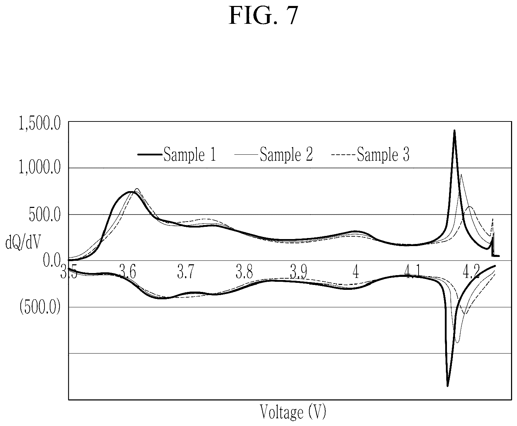

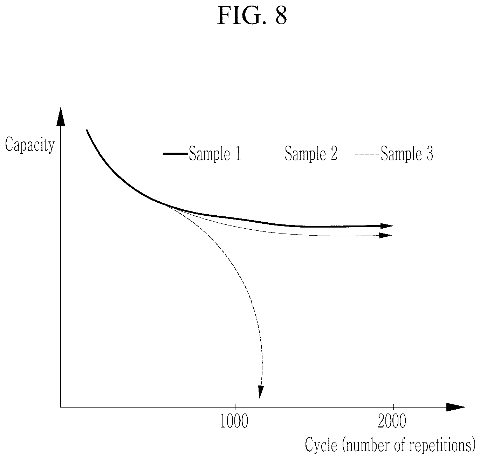

FIG. 7 is a diagram showing an example of capacity-to-voltage differential characteristic data for each cycle in a learning sample, and FIG. 8 is a diagram showing an example of life data for each cycle in a learning sample.

Although only three samples are shown in FIGS. 7 and 8, the number of learning data may be sufficient to train a life prediction model, and the prediction accuracy of the life prediction model may increase as the amount of training data increases.

Referring back to FIG. 6, the learning device may learn the life prediction model using the capacity-to-voltage differential characteristic data and life data for each cycle of each learning sample (S620). The life prediction model may learn the correlation between the voltage range in which capacity decreases, and may learn the life deterioration tendency according to each cycle, using the capacity-to-voltage differential characteristic data and the life data for each cycle of each learning sample, and may predict and classify a long-life battery and a short-life battery.

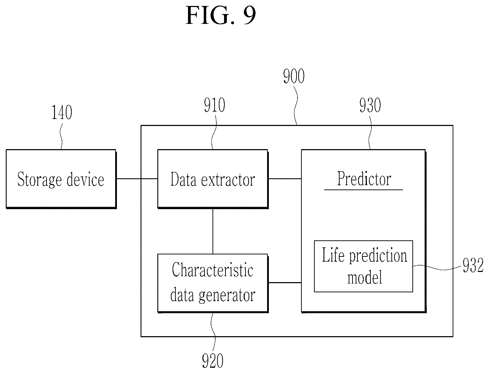

FIG. 9 is a diagram showing a life prediction apparatus according to an embodiment.

Referring to FIG. 9, the life prediction apparatus 900 may include a data extractor 910, a characteristic data generator 920, and a predictor 930. The life prediction apparatus 900 may be implemented within the battery test apparatus 100 and may be a separate and independent device from the battery test apparatus.

The data extractor 910 may extract current and voltage data corresponding to test result data from the storage device 140 based on the life evaluation command using tag information of "life" indicating the life evaluation.

The characteristic data generator 920 may calculate capacity data for each cycle using current data extracted for each cycle, and may calculate capacity-to-voltage differential characteristic data for each cycle by differentiating the capacity data for each cycle into voltage data for each cycle.

The predictor 930 may include a life prediction model 932. The predictor 930 may input capacity-to-voltage differential characteristic data for each cycle into the life prediction model 932. The life prediction model 932 may receive capacity-to-voltage differential characteristic data for each cycle as input, and may output a life prediction result corresponding to the capacity-to-voltage differential characteristic data for each cycle.

In this way, using the life prediction model 932, life prediction results may be output even with a small amount of data. For example, the life prediction model 932 may be learned using data obtained from the entire life of 500 cycles, but if predicting the life of the battery that is the target of prediction using the learned life prediction model 932, accurate life prediction results may be obtained even if only data obtained from 200 cycles are used.

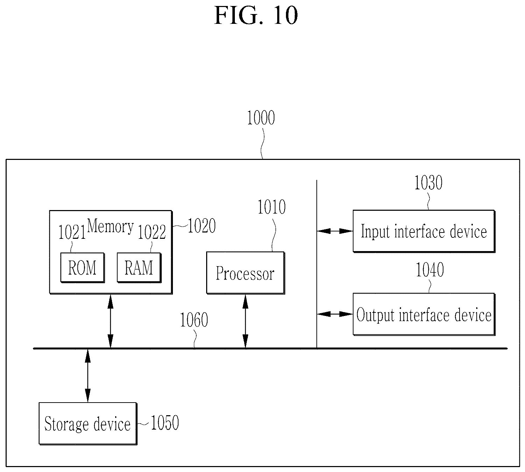

FIG. 10 is a diagram showing a battery test apparatus according to another embodiment.

Referring to FIG. 10, the battery test apparatus 1000 may represent a computing device that implements the battery test method and/or the method for predicting the life of a test battery described above.

The battery test apparatus 1000 may include at least one of a processor 1010, a memory 1020, an input interface device 1030, an output interface device 1040, and a storage device 1050. Each component may be connected by a bus 1060 and may communicate with each other. Additionally, each component may be connected through an individual interface or individual bus centered on the processor 1010, rather than the common bus 1060.

The processor 1010 may be implemented as various types such as an application processor (AP), a central processing unit (CPU), a graphics processing unit (GPU), etc., and may be any semiconductor device that executes a command stored in the memory 1020 or storage device 1050. The processor 1010 may execute program commands stored in at least one of the memory 1020 and the storage device 1050. This processor 1010 may be configured to implement the functions and methods described based on FIGS. 1 to 9 above.

The memory 1020 and storage device 1050 may include various types of volatile or non-volatile storage media. For example, the memory 1020 may include read-only memory (ROM) 1021 and random access memory (RAM) 1022. In an embodiment, the memory 1020 may be located inside or outside the processor 1010, and the memory 1020 may be connected to the processor 1010 through various known means.

The input interface device 1030 may be configured to provide data to the processor 1010.

The output interface device 1040 may be configured to output data from the processor 1010.

According to at least one of the embodiments, data to be extracted may be quickly (or suitably) extracted using tag information.

Although the embodiments of the present disclosure have been described in detail above, the scope of the present disclosure is not limited thereto, and various modifications and improvements of those skilled in the art using the basic concepts of the present disclosure as defined in the appended claims, with functional equivalents thereof to be included therein, are also included in the present disclosure.

### <Description of symbols>

10: battery
11: battery module
13: relay
15: BMS
17, 19: connector
100: battery test apparatus
110: test chamber
120: controller
130: charge-and-discharge device
140: storage device
10: battery module
11, 12, 13, 14: cell
900: life prediction apparatus
910: data extractor
920: characteristic data generator
930: predictor
932: life prediction model
1000: battery test apparatus
1010: processor
1020: memory,
1030: input interface device
1040: output interface device
1050: storage device
1060: common bus

## Claims

1. A battery test method for testing a battery (10) in a battery test apparatus (100, 1000), the battery test method comprising:
generating a test pattern (300) in which a cycle (310) including at least one operation step for a test list and a loop (320) including a number of repetitions of the cycle (310) are set, based on user input;
setting a tag (330, 332, 334) indicating a test type in the at least one operation step according to the test type within the cycle (310) for the test list;
testing the battery (10) by charging and discharging the battery (10) according to the test pattern (300); and
storing voltage data and current data in memory (1020) as a test result for the test pattern (300).

2. The battery test method as claimed in claim 1, wherein
the storing voltage data and current data comprises tagging the information of the tag (330, 332, 334) in a test result corresponding to an operation step in which the tag (330, 332, 334) is set.

3. The battery test method as claimed in claim 1 or 2, wherein
the test type comprises at least one of an internal resistance of the battery (10), a capacity of the battery (10), a temperature of the battery (10), a life of the battery (10), a charge and discharge rate of the battery (10), and a formation of the battery (10).

4. The battery test method as claimed in any one of the preceding claims, further comprising:
receiving a life test command of the battery (10);
extracting current data and voltage data for each cycle (310) tagged with information of a tag (330, 332, 334) indicating a life of the battery (10) from the memory (1020); and
predicting the life of the battery (10) using the current data and voltage data for each cycle (310).

5. The battery test method as claimed in claim 4, wherein
the predicting the life of the battery (10) comprises:
calculating capacity data for each cycle (310) using the current data for each cycle (310);
calculating capacity-to-voltage differential characteristic data for each cycle (310) using the capacity data for each cycle (310) and the voltage data for each cycle (310); and
predicting the life of the battery (10) from the capacity-to-voltage differential characteristic data for each cycle (310) using a life prediction model (932).

6. The battery test method as claimed in any one of the preceding claims, wherein each of the at least one operation step comprises any one of a charge step, a rest step, and a discharge step.

7. The battery test method as claimed in any one of the preceding claims, wherein each of the at least one operation step further comprises an operation condition (312) and an end condition (314).

8. A battery test apparatus (100, 1000) for testing a battery (10), the battery test apparatus (100, 1000) comprising:
a storage device (1050);
a charge-and-discharge device (130) electrically connected to the battery (10) and charging and discharging the battery (10) according to a test pattern (300) including at least one test list; and
a controller (120) that is configured to generate the battery pattern based on user input, provide the battery pattern to the charge-and-discharge device (130), control testing of the battery (10), and store test result data in the storage device (1050) in response to the battery pattern,
wherein the at least one test list comprises a cycle (310) including at least one operation step and a loop (320) including the number of repetitions of the cycle (310), and
the controller (120) is configured to set a tag (330, 332, 334) indicating a test type in the at least one operation step according to the test type.

9. The battery test apparatus (100, 1000) as claimed in claim 8, wherein the controller (120) is configured to tag (330, 332, 334) test result data corresponding to the operation step in which the tag (330, 332, 334) is set with the information of the tag (330, 332, 334), and store the test result data tagged with the information of the tag (330, 332, 334).

10. The battery test apparatus (100, 1000) as claimed in claim 8 or 9, wherein
the test type comprises at least one of an internal resistance of the battery (10), a capacity of the battery (10), a temperature of the battery (10), a life of the battery (10), a charge and discharge rate of the battery (10), and a formation of the battery (10).

11. The battery test apparatus (100, 1000) as claimed in any one of claims 8 to 10, wherein
the controller (120) is configured to extract test result data tagged with information on a tag (330, 332, 334) corresponding to a test type input from the user from the storage device (1050), and evaluate the test type using the extracted test result data.

12. The battery test apparatus (100, 1000) as claimed in any one of claims 8 to 11, wherein
the controller (120) is configured to extract test result data tagged with information on a tag (330, 332, 334) indicating a life of the battery (10) from the storage device (1050) based on a battery life test command, and evaluate the life using the extracted test result data.

13. The battery test apparatus (100, 1000) as claimed in claim 11 or 12, wherein
the controller (120) is configured to evaluate the life from the test result data extracted using a learned life prediction model (932).

14. The battery test apparatus (100, 1000) as claimed in any one of claims 8 to 13, wherein each of the at least one operation step comprises any one of a charge step, a rest step, and a discharge step.

15. The battery test apparatus (100, 1000) as claimed in any one of claims 8 to 14, wherein each of the at least one operation step further comprises an operation condition (312) and an end condition (314).
